# EUROPÄISCHE PATENTANMELDUNG

(11) **EP 1 727 222 A2**
(43) Veröffentlichungstag der Anmeldung: **29.11.2006**
(21) Anmeldenummer: 06009885.2
(22) Anmeldetag: 12.05.2006
(51) Int. Cl.: H01L 51/52

(54) **Transparentes lichtemittierendes Bauteil**

(30) Priorität: 27.05.2005 EP 05011427; 12.07.2005 EP 05015072
(71) Anmelder: Novaled AG, 01307 Dresden (DE)
(72) Erfinder: Leo, Karl, 01219 Dresden (DE); Gehlhaar, Robert, 01219 Dresden (DE); Lyssenko, Vadim, 01069 Dresden (DE)
(74) Vertreter: Bittner, Thomas L.

(57) **Zusammenfassung**

Die Erfindung betrifft ein transparentes lichtemittierendes Bauteil, insbesondere organische Leuchtdiode (OLED), mit einer Schichtanordnung, in welcher zwischen einer oberen und einer unteren Elektrode eine lichtemittierende organische Schicht angeordnet ist, wobei die Schichtanordnung in einem ausgeschalteten Zustand transparent und in einem eingeschalten Zustand mittels Anlegen einer elektrischen Spannung an die obere und die untere Elektrode in der lichtemittierenden organischen Schicht erzeugtes Licht emittiert, welches in einem Verhältnis von mindestens etwa 4:1 durch die obere oder die untere Elektrode abgestrahlt wird, und wobei auf der Seite der oberen oder der unteren Elektrode ein im sichtbaren Spektralbereich transparenter Stapel dielektrischer Schichten angeordnet ist.

## Beschreibung

Die Erfindung bezieht sich auf ein transparentes lichtemittierendes Bauteil, insbesondere eine organische Leuchtdiode (OLED).

### Hintergrund der Erfindung

Organische Leuchtdioden haben sich in letzter Zeit sehr schnell entwickelt. Obwohl sie erst 1987 für aufgedampfte organische Materialien (vgl. Tang et al., Appl. Phys. Lett. 51 (12), 913 (1987)) für aus flüssiger Lösung aufgebrachte polymere Materialien (vgl. J. H. Burroughes et al., Nature 347, 6293 (1990)) entwickelt wurden, konnte in den letzten Jahren bereits exzellente Parameter für die Effizienz und Lebensdauern organischer Leuchtdioden erzielt werden. Insbesondere gelang es, für grün emittierende Leuchtdioden Effizienzen von über 80 Lumen / W zu erreichen (vgl. He et al., Appl. Phys. Lett. 85, 3911 (2004)). Auch für rot emittierende und blau emittierende organische Leuchtdioden konnten bereits vergleichsweise gute Werte erreicht werden.

Da auch die Lebensdauer dieser Systeme sehr schnell gewachsen ist und inzwischen Werte von 10.000 Stunden für einige Materialsysteme bereits deutlich überschritten hat, erscheinen organische Leuchtdioden auch für Anwendungen in Beleuchtungssystemen interessant. Die wesentlichen Vorteile der organischen Leuchtdioden sind neben der möglichen hohen Effizienz, die bereits heute diejenige von Glühbirnen überschreitet und in Zukunft möglicherweise die Effizienz von Leuchtstoffröhren erreicht, die Möglichkeit, eine großflächige Beleuchtungseinheit zu realisieren, wodurch sehr blendfreies und für viele Anwendung ideal geeignetes Licht erzeugt werden kann.

Der übliche Aufbau für organische Leuchtdioden umfaßt ein transparentes Substrat, meistens Glas, das mit einer transparenten Anode beschichtet wird, die häufig aus Indiumzinnoxid oder Indiumthinoxid (ITO) gebildet ist. Darauf werden aktive organische Schichten abgeschieden und anschließend noch eine metallische Kathode zur elektrischen Kontaktierung aufgebracht. Werden einige Volt Spannung zwischen der metallischen Kathode und der transparenten Anode angelegt, so emittiert die Leuchtdiode durch das Substrat das Licht.

Es gibt auch technische Ansätze, die es erlauben, Leuchtdioden zu konstruieren, die zumindest teilweise transparent sind. Dazu kann beispielsweise die Kathode ebenfalls mit einem transparenten leitfähigem Metall oder mit einer dünnen, teilweise transparenten Metallschicht versehen werden (vgl. Gu et al., Appl. Phys. Lett. 68, 2606 (1996); Parthasaray et al., Appl. Phys. Lett. 76, 2128 (2000)). In den bisher vorgeschlagenen Anordnungen wird das Licht der Leuchtdiode dann in beide Richtungen emittiert, wobei das genaue Verhältnis der in die beiden Richtungen ausgestrahlten Lichtmengen vom Aufbau der Schichtanordnung abhängt. Dies ist für manche Anwendungen brauchbar, beispielsweise für Displays, die von beiden Seiten gelesen werden sollen.

Für Beleuchtungsanwendungen hingegen ist es oft nachteilig, wenn eine transparente Leuchtdiode in beide Seiten emittiert. Andererseits wäre es sehr günstig, wenn es möglich wäre, organische Leuchtdioden zu realisieren, die transparent sind und gleichzeitig deutlich bevorzugt in eine Richtung emittieren. Bei den aus der Literatur bekannten Ansätzen sind die Leuchtstärken in beiden Richtungen annähernd gleich (vgl. Gu et al., Appl. Phys. Lett. 68, 2606 (1996); Parthasaray et al., Appl. Phys. Lett. 76, 2128 (2000)).

### Zusammenfassung der Erfindung

Aufgabe der Erfindung ist es, ein transparentes lichtemittierendes Bauteil zu schaffen, welches für Beleuchtungszwecke besser geeignet ist.

Diese Aufgabe wird durch transparentes lichtemittierendes Bauteil nach Anspruch 1 gelöst. Vorteilhafte Ausgestaltungen der Erfindung sind Gegenstand von abhängigen Unteransprüchen.

Erfindungsgemäß ist ein transparentes lichtemittierendes Bauteil, insbesondere organische Leuchtdiode (OLED), mit einer Schichtanordnung geschaffen, in welcher zwischen einer oberen und einer unteren Elektrode eine lichtemittierende organische Schicht angeordnet ist, wobei die Schichtanordnung in einem ausgeschalteten Zustand transparent und in einem eingeschalten Zustand mittels Anlegen einer elektrischen Spannung an die obere und die untere Elektrode in der lichtemittierenden organischen Schicht erzeugtes Licht emittiert, welches in einem Verhältnis von mindestens etwa 4:1 durch die obere oder die untere Elektrode abgestrahlt wird, und wobei auf der Seite der oberen oder der unteren Elektrode ein im sichtbaren Spektralbereich transparenter Stapel dielektrischer Schichten angeordnet ist.

Mit Hilfe der Erfindung ist es ermöglicht, einerseits im ausgeschalteten Zustand des lichtemittierenden Bauteils eine hohe optische Transparenz im sichtbaren Spektralbereich zu erzielen. Andererseits kann das Bauteil im eingeschalteten Zustand weißes oder auch farbiges Licht präferentiell in eine Richtung emittieren, wobei ein Verhältnis von etwa 4:1 erreicht oder überschritten wird. Bei dem vorgeschlagenen Bauteil ist eine Integration einer lichtemittierenden Schichtanordnung, bei der es sich bevorzugt um eine organischen Leuchtdiode handelt, mit einem Stapel dielektrischer Schichten vorgesehen. Mit Hilfe dieser Anordnung werden die Wellenlängen des in der lichtemittierenden organischen Schicht erzeugten Lichtes bevorzugt in eine Richtung emittiert.

Der Stapel dielektrischer Schichten ist bei einer Ausführungsform so gestaltet, dass in einem begrenzten Spektralbereich, der mit dem Emissionssprektrum des in der lichtemittierenden organischen Schicht erzeugten Lichtes zumindest teilweise überlappt, ein hohes Reflexionsvermögen (>90%) aufweist, wobei ein Reflexionsvermögen von >99% ausbildbar ist mit mehreren Schichten. Hierdurch wird ein wesentlicher Teil des in der lichtemittierenden organischen Schicht, welche ihrerseits als Schichtfolge gebildet sein kann, erzeugten Lichtes nur in eine Richtung emittiert, also bevorzugt durch die obere oder die untere Elektrode.

Gleichzeitig ist die Transmission des Bauteils im gesamten sichtbaren Spektralbereich sehr hoch. Dies kann beispielsweise dadurch erreicht werden, dass der Stapel dielektrischer Schichten so ausgelegt wird, dass das Reflexionsband so schmal ist, dass nur die wesentlichen Teile der Emission der lichtemittierenden organischen Schicht reflektiert werden. Die Auslegung des Stapels dielektrischer Schichten kann dadurch neben den λ/4-Schichten, die in der einfachsten Form einer solchen spiegelnden Anordnung verwendet werden, auch mehrfache dieser Dicke für eine oder beide Teilkomponenten des Schichtstapels enthalten, wodurch die spektrale Reflexionsbreite reduziert wird (vgl. Macleod, Thin Film Optical Filters, 3rd ed., IOP Publishing 2001). Um eine möglichst hohe Transmission zu erreichen, ist die Schichtdicke des üblicherweise verwendeten transparenten Kontaktmaterials Indiumzinnoxid (ITO) optimiert; Rechnungen ergeben beispielsweise, dass dies für die Schichtdicke λ/4 der Fall ist.

Die hier vorgeschlagene Anordnung kann in einer Ausführungsform auch vorteilhaft dahingehend erweitert werden, dass der Stapel dielektrischer Schichten nicht nur eine Wellenlänge bevorzugt reflektiert, sondern mehrere, schmale Wellenlängenbereiche reflektiert werden. Dies kann entweder mittels der sequentiellen Abscheidung mehrerer Stapel mit verschiedenen Dicken der Einzelschichten oder mittels Ausnutzung der höheren Reflexionsordnungen eines einfachen Schichtstapels erreicht werden. Hierdurch ist beispielsweise möglich, auch eine Weißlicht emittierende, transparente, organische Leuchtdiode zu realisieren.

In einer weiteren Ausführungsform werden die dielektrischen Schichten mit einer Dicke von λ/4 und moduliertem oder kontinuierlich variiertem Brechungsindexprofil, sogenannte Rugatefilter, verwendet. Diese bieten bei geeigneter Konstruktion den Vorteil der Unterdrückung der bei herkömmlichen Braggspiegeln auftretenden Reflexionsbänder außerhalb des Bereichs der mit angestrebt hoher Reflexion. Die Verwendung eines solchen dielektrischen Filters ermöglicht die Reflexion im gewünschten Spektralbereich mit einer Effizienz >99% und einer ebenfalls sehr hohen Transparenz (>90%) in den anderen Bereichen des visuellen Spektrums.

Das hier vorgeschlagene Prinzip ist sehr allgemein anwendbar und ist zum Beispiel von der genauen Natur der Schichtanordnung unabhängig. Beispielsweise ist es sowohl für aus der Lösung aufgebrachte als auch für im Vakuum aufgedampfte Schichtanordnungen oder für hybride Schichtanordnungen, die mittels beider Technologien aufgebrachte Schichten umfassen, verwendbar. Weiterhin kann es auch für organische Leuchtdioden verwendet werden, wenn diese in einem Stapel aus zwei oder mehreren Dioden monolithisch integriert sind. Das abgestrahlte Licht wird in diesem Fall mit Hilfe mehrerer organischer Leuchtdioden erzeugt.

### Beschreibung bevorzugter Ausführungsbeispiele der Erfindung

Die Erfindung wird im folgenden anhand von Ausführungsbeispielen unter Bezugnahme auf Figuren einer Zeichnung näher erläutert. Hierbei zeigen:
- Fig. 1: eine schematische Darstellung einer transparenten Schichtanordnung für ein lichtemittierendes Bauteil;
- Fig. 2: ein Transmissionsspektrum für eine Ausführungsform einer Schichtanordnung nach Fig. 1; und
- Fig. 3a und 3b: ein Transmissionsspektrum und eine Brechungsindex-Verteilung für eine weitere Ausführungsform einer Schichtanordnung nach Fig. 1 mit moduliertem Brechungsindex.

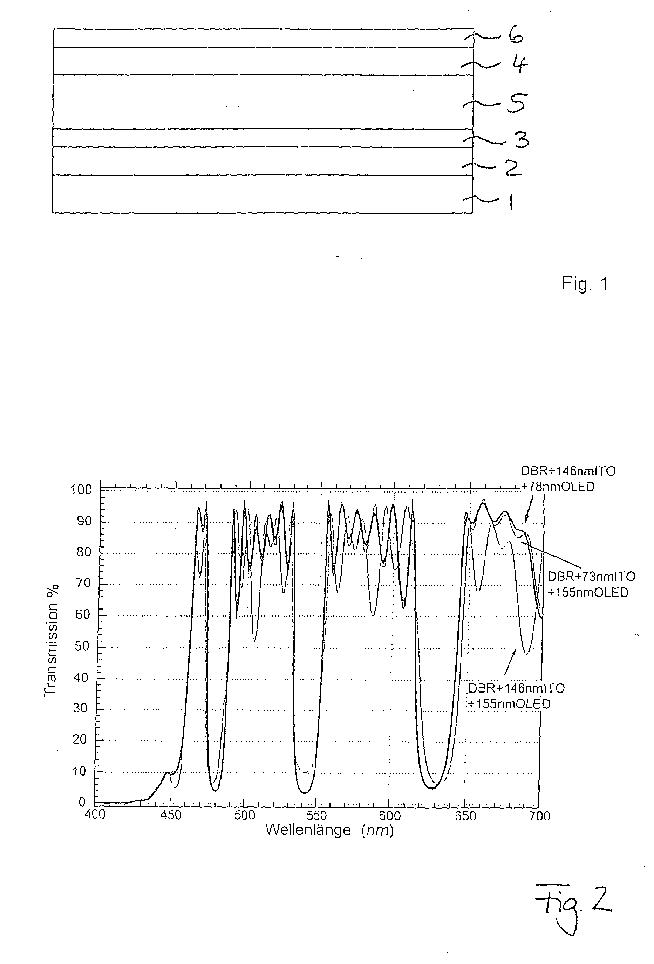

Fig. 1 zeigt eine schematische Darstellung einer transparenten Schichtanordnung für ein lichtemittierendes Bauteil, insbesondere eine organische Leuchtdiode (OLED). Auf einem Substrat 1 ist ein Stapel 2 dielektrischer Schichten angeordnet, auf den eine untere transparente Elektrode 3 folgt. Gegenüber der unteren Elektrode 3 ist eine obere transparente Elektrode 4 angeordnet. Zwischen der unteren und der oberen Elektrode 3, 4 ist ein organischer Bereich 5 angeordnet. Der organische Bereich 5 ist aus einem oder mehreren organischen Materialien gebildet und enthält mindestens eine lichtemittierende organische Schicht, in welcher beim Anlegen einer elektrischen Spannung an die untere und die obere Elektrode 3, 4 Licht erzeugt wird. Die lichtemittierende organische Schicht ist wahlweise als Einzelschicht oder Folge von Schichten gebildet, wie dieses in verschiedenen Ausführungen für organische Leuchtdioden bekannt ist. In ähnlicher Weise kann der organische Bereich 5 weitere organische Schichten umfassen, beispielsweise dotierte oder undotierte Löcher- oder Elektronentransportschichten. Auch Zwischenschichten können vorgesehen sein. Den Abschluss der transparenten Schichtanordnung bildet eine Kapselung 6, die zum Ausschluss von Umwelteinflüssen dient.

Eine vorteilhafte Ausführung einer Schichtanordnung nach Fig. 1 für ein transparentes lichtemittierendes Bauteil umfaßt die folgenden Schichten / Schichtfolgen:
1. Träger, Substrat
2. Stapel aus im sichtbaren Spektralbereich transparenten Materialien (Dielektrika), beispielsweise fünf Schichten SiO₂/TiO₂ mit einer Dicke von jeweils λ/4
3. transparente Elektrode, beispielsweise ITO, Löcher injizierend (Anode)
4. p-dotierte, Löcher injizierende und transportierende Schicht
5. lichtemittierende organische Schicht (wahlweise mit Emitterfarbstoff dotiert)
6. n-dotierte, Elektronen injizierende und transportierende Schicht,
7. transparente Elektrode, Elektronen injizierend (Kathode),
8. Kapselung zum Ausschluß von Umwelteinflüssen.

Die mit den Ziffern 4. bis 6. bezeichneten Schichten bilden wiederum den organischen Bereich 5 (vgl. Fig. 1).

Für die Realisierung einer transparenten organischen Leuchtdioden, die in zwei oder drei Wellenlängenbereichen emittiert, können zum einen mehrere Stapel dielektrischer Schichten mit der jeweiligen Einzelschichtdicke λ/4 übereinander gelegt werden. Hierdurch werden jeweilige spektrale Bänder reflektiert und geben in der Überlagerung das gewünschte Spektrum des emittierten Lichtes.

Eine weitere Möglichkeit besteht darin, höhere Ordnungen eines periodischen Stapels dielektrischer Schichten zu nutzen. Da bei einer λ/4-Anordnung diese höheren Ordnungen jeweils bei der halben Wellenlänge der nächstniedrigen Ordnung liegen, könnte so innerhalb des sichtbaren Spektralbereichs kaum eine Überlagerung mehrer Banden erreicht werden. Werden jedoch für die längste zu überlagernde Wellenlänge bereits Vielfache von λ/4-Schichtdicken verwendet, so können von einem Stapel dielektrischer Schichten mit einheitlichen Schichtdicken mehrere Spektralbereiche innerhalb des sichtbaren Lichts überlagert werden.

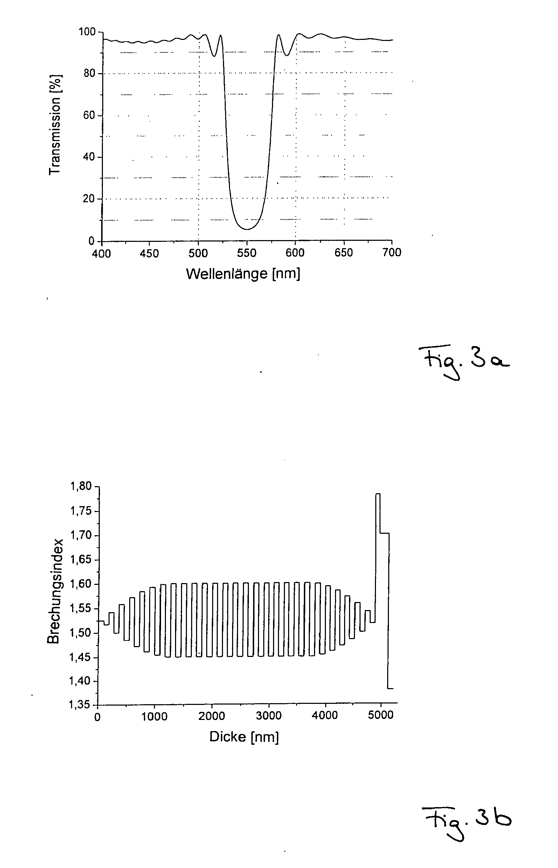

Ein bevorzugtes Ausführungsbeispiel zeigt die in Fig. 2 dargestellten Transmissionsspektren und weist den folgenden Aufbau auf:
1. Träger, Substrat, Glas
2. Stapel dielektrischer Schichten ("Distributed Bragg Reflector", DBR) aus im sichtbaren Spektralbereich transparenten Materialien (Dielektrika) mit drei Doppelschichten SiO2/TiO2 mit einer Dicke von jeweils 13λ/4
3. transparente Elektrode, beispielsweise ITO, Löcher injizierend (Anode), Dicke 146nm (dicke durchgezogene und gepunktete Linie in Fig. 2) oder 73nm (dünne durchgezogene Linie in Fig.2)
4. p-dotierte, Löcher injizierende und transportierende Schicht
5. lichtemittierende Schicht (wahlweise mit Emitterfarbstoff dotiert)
6. n-dotierte, Elektronen injizierende und transportierende Schicht
7. transparente Elektrode, Elektronen injizierend (Kathode)
8. Kapselung zum Ausschluß von Umwelteinflüssen.

Die mit den Ziffern 4. bis 6. bezeichneten Schichten bilden wiederum den organischen Bereich.

Fig. 2 zeigt das Transmissionsspektrum einer solchen Anordnung, wobei die Kapselung in der optischen Modellierung nicht berücksichtigt ist. Die Gesamtdicke der organischen Schichten 3. bis 5. wurde mit 78nm (dicke durchgezogene Linie) oder 155nm (gepunktete und dünne durchgezogene Linie) angesetzt, die Schichten 6. und 7. wurden als eine λ/4-Schicht mit dem Brechungsindex 1,38 modelliert. Es ergibt sich, dass diese Anordnung bei etwa 630nm, 540nm und 480nm jeweils eine hohe Reflexion zeigt. Auf diese Weise kann mit einer solchen Anordnung eine stark asymmetrische Emission erzielt werden, obwohl die gesamte Transmission noch größer als 60% ist.

Ein weiteres bevorzugtes Ausführungsbeispiel weist den folgenden Aufbau auf:
1. Träger, Substrat, Glas
2. Stapel dielektrischer Schichten aus im sichtbaren Spektralbereich transparenten Materialien (Dielektrika) mit teilweise moduliertem Brechungsindex zwischen 1,45 (zum Beispiel SiO₂ und 1,6 (zum Beispiel Al₂O₃)
3. transparente Elektrode, beispielsweise ITO, Löcher injizierend (Anode), Dicke 77nm
4. p-dotierte, Löcher injizierende und transportierende Schicht
5. lichtemittierende Schicht (wahlweise mit Emitterfarbstoff dotiert)
6. n-dotierte, Elektronen injizierende und transportierende Schicht
7. transparente Elektrode, Elektronen injizierend (Kathode)
8. Kapselung zum Ausschluß von Umwelteinflüssen.

Fig. 3a zeigt das Transmissionsverhalten für das weitere Ausführungsbeispiel ohne Berücksichtigung der Kapselung. Der Stapel dielektrischer Schichten umfasst 54 Schichten mit teilweise sinusförmig moduliertem Brechungsindex und ist für eine maximale Reflexionswellenlänge von 550nm konstruiert.

Fig. 3b zeigt eine variierende Brechungsindex-Verteilung in dem Stapel dielektrischer Schichten, wobei jeder dielektrischen Schicht in dem Stapel einer der variierenden Brechungsindizes zugeordnet ist. Auf dem Stapel dielektrischer Schichten befindet sich eine 77nm dicke Schicht ITO. Die Gesamtdicke der organischen Schichten beträgt 162nm, die der 7. Schicht (transparente Elektrode) 100nm. Diese Konstruktion ermöglicht eine hohe Reflexion um 550nm bei einer Gesamttransmission von >80%.

Es kann auch vorgesehen sein, in zumindest einem Teilstapel des Stapels dielektrischer Schichten eine Folge benachbarter Schichten mit kontinuierlich zunehmendem / abnehmendem Brechungsindex vorzusehen. Diese Zunahme / Abnahme kann insbesondere mittels Variation der Schichtdicke der einzelnen Schichten des Teilstapels erreicht werden. Hierdurch können die hier störenden oszillierenden Nebenmaxima der Stopbänder unterdrückt werden.

Die in der vorstehenden Beschreibung, den Ansprüchen und den Zeichnungen offenbarten Merkmale der Erfindung können sowohl einzeln als auch in beliebiger Kombination für die Verwirklichung der Erfindung in ihren verschiedenen Ausführungsformen von Bedeutung sein.

## Patentansprüche

1. Transparentes lichtemittierendes Bauteil, insbesondere organische Leuchtdiode (OLED), mit einer Schichtanordnung, in welcher zwischen einer oberen und einer unteren Elektrode eine lichtemittierende organische Schicht angeordnet ist, wobei die Schichtanordnung in einem ausgeschalteten Zustand transparent und in einem eingeschalten Zustand mittels Anlegen einer elektrischen Spannung an die obere und die untere Elektrode in der lichtemittierenden organischen Schicht erzeugtes Licht emittiert, welches in einem Verhältnis von mindestens etwa 4:1 durch die obere oder die untere Elektrode abgestrahlt wird, **dadurch gekennzeichnet, dass** auf der Seite der oberen oder der unteren Elektrode ein im sichtbaren Spektralbereich transparenter Stapel dielektrischer Schichten aus zwei oder mehr Materialien mit unterschiedlichen Brechungsindizes angeordnet ist.

2. Transparentes lichtemittierendes Bauteil nach Anspruch 1, **dadurch** gekennzeich- net, dass das Emissionspektrum des in der lichtemittierenden organischen Schicht erzeugten Lichtes und ein spektraler Reflexionsbereich des Stapels dielektrischer Schichten, in welchem der Stapel dielektrischer Schichten ein hohes Reflexionsvermögen (>90%) aufweist, zumindest teilweise überlappend ausgebildet sind.

3. Transparentes lichtemittierendes Bauteil nach Anspruch 1 oder 2, **dadurch gekennzeichnet, dass** die dielektrischen Schichten jeweils eine Schichtdicke von (n x λ/4) aufweisen, wobei n=1, 2, ... und λ eine Wellenlänge des emittierten Lichts ist.

4. Transparentes lichtemittierendes Bauteil nach einem der vorangehenden Ansprüche, **dadurch gekennzeichnet, dass** der Stapel dielektrischer Schichten direkt auf die obere oder die untere Elektrode aufgebracht ist.

5. Transparentes lichtemittierendes Bauteil nach einem der vorangehenden Ansprüche, **dadurch gekennzeichnet, dass** die lichtemittierende organische Schicht als eine Schichtfolge mit mehreren Schichten gebildet ist.

6. Transparentes lichtemittierendes Bauteil nach einem der vorangehenden Ansprüche, **dadurch gekennzeichnet, dass** die Schichtanordnung Weißlicht emittierend gebildet ist, wobei das Weißlicht aus mehreren spektralen Komponenten des in der lichtemittierenden organischen Schicht erzeugten Lichtes zusammengesetzt ist.

7. Transparentes lichtemittierendes Bauteil nach einem der vorangehenden Ansprüche, **dadurch gekennzeichnet, dass** der Stapel für verschiedene spektrale Komponenten des in der lichtemittierenden organischen Schicht erzeugten Lichtes unterschiedliche Ordnungen des Stapels dielektrischer Schichten zur Reflexion benutzt, sodass mit dem Stapel mit einheitlicher Schichtdicke mehrere Reflexionsbänder genutzt werden können.

8. Transparentes lichtemittierendes Bauteil nach einem der vorangehenden Ansprüche, **dadurch gekennzeichnet, dass** die lichtemittierende organische Schicht in einer organischen Leuchtdiode gebildet ist und dass mindestens eine weitere organische Leuchtdiode mit einer weiteren lichtemittierenden organischen Schicht gebildet ist, wobei die organische Leuchtdiode und die mindestens eine weitere organische Leuchtdiode übereinander gestapelt sind.

9. Transparentes lichtemittierendes Bauteil nach einem der vorangehenden Ansprüche, **dadurch gekennzeichnet, dass** zumindest ein Teil der dielektrischen Schichten des Stapels dielektrischer Schichten jeweils einen unterschiedlichen Brechungsindex aufweist.

10. Transparentes lichtemittierendes Bauteil nach einem der vorangehenden Ansprüche, **dadurch gekennzeichnet, dass** für zumindest einen Teil der dielektrischen Schichten in dem Stapel dielektrischer Schichten eine modulierte Brechungsindex-Verteilung gebildet ist.

11. Transparentes lichtemittierendes Bauteil nach Anspruch 10, **dadurch gekennzeichnet, dass** die modulierte Brechungsindex-Verteilung im wesentlichen oszillierend gebildet ist.

12. Transparentes lichtemittierendes Bauteil nach einem der vorangehenden Ansprüche, **dadurch gekennzeichnet, dass** für zumindest einen Teil der dielektrischen Schichten in dem Stapel dielektrischer Schichten eine Folge von kontinuierlich zunehmenden / abnehmenden Brechungsindizes gebildet ist.
